(19) Europäisches Patentamt
European Patent Office
Office européen des brevets

(11) **EP 3 164 727 B1**

(12) **EUROPEAN PATENT SPECIFICATION**

(45) Date of publication and mention
of the grant of the patent:
**02.03.2022 Bulletin 2022/09**

(21) Application number: **15814623.3**

(22) Date of filing: **23.06.2015**

(51) International Patent Classification (IPC):
***G01R 31/36*** *(2020.01)*     ***H02J 7/00*** *(2006.01)*
***G01R 31/389*** *(2019.01)*

(52) Cooperative Patent Classification (CPC):
**H02J 7/0047; G01R 31/389;** G01R 31/387

(86) International application number:
**PCT/SE2015/050725**

(87) International publication number:
**WO 2016/003355 (07.01.2016 Gazette 2016/01)**

(54) **A METHOD, A CIRCUIT, AND A BATTERY CHARGER**

VERFAHREN, SCHALTUNG UND BATTERIELADEGERÄT

PROCÉDÉ, CIRCUIT, ET CHARGEUR DE BATTERIE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **03.07.2014 SE 1450842**

(43) Date of publication of application:
**10.05.2017 Bulletin 2017/19**

(73) Proprietor: **CTEK Sweden AB
776 70 Vikmanshyttan (SE)**

(72) Inventor: **FRÖJD, Hans-Olof
805 98 Gävle (SE)**

(74) Representative: **Brann AB
P.O. Box 3690
Drottninggatan 27
103 59 Stockholm (SE)**

(56) References cited:
**EP-A1- 1 835 297          WO-A2-02/097456
GB-A- 2 278 452          US-A- 6 114 838
US-A1- 2002 075 003     US-A1- 2005 208 368
US-A1- 2007 216 367**

## Description

## TECHNICAL FIELD

The present invention generally relates to a method and a circuit for a battery charger. More particularly the present invention relates to a method and a circuit for determining the capacity of a battery connected to a battery charger.

## BACKGROUND

A common problem during charging of batteries is to estimate the capacity of the connected battery. The capacity of the connected battery is the amount of electrical charge the connected battery can deliver at a rated voltage. The capacity of the connected battery is proportional to the amount of electrode material used in the battery. The capacity can be used to calculate a necessary charging time and/or an appropriate charging current.

A well-known method in the art is disclosed by W. Peukert in an article "Elektrotechnische Zeitsschrift 20 (1997) 20-21", which method utilizes a constant current discharge in order to determine the remaining capacity of a connected battery. This method is of great importance for determining the remaining capacity of a battery. But this method is rather complex and utilizes a discharge of the battery using a constant current and is therefore not suitable for a battery charger.

Two different methods of determining the required charging time exists in the art. The first method uses historic charging data as input to a model, an example of this method can be found in US5926007. A problem of this solution is that if pluralities of batteries are charged, the usability of the method is severely limited. A solution to this problem can be found in US6928372. In this solution the battery is equipped with a memory configured to store charging states, charging procedures and battery identifiers. In this method the battery charger retrieves the necessary data from the memory of the battery and the time remaining for completion of the charging is estimated by means of summing-up the times for completion of the respective charging state.

US 2002/075003 A1 describes a battery condition determination method. A test pulse is applied to a battery. The battery voltages at the beginning and at the end of the test pulse are measured to determine a state of deterioration of the battery, a charge capacity and an appropriate charging current for the battery.

None of the methods teaches a way to determine the capacity of the connected battery; instead these two methods rely on historic data or user input.

Hence, there exists a need for an improved method and circuit for determining the capacity of the connected battery.

A fast and robust method to determine the capacity of a connected battery is of great interest especially for tailoring optimum charging characteristics.

## SUMMARY

It is an object of exemplary embodiments of the invention to address at least some of the issues outlined above. This object and others are achieved by the method, the circuit, and the battery charger according to the appended independent claims, and by the embodiments according to the dependent claims.

The present invention provides a method for determining a capacity of a battery. The method comprises generating an electrical pulse across a plus terminal and a minus terminal of the connected battery. The method further comprises measuring a first voltage (V1) across the plus terminal and the minus terminal at a first time during said pulse, measuring a second voltage (V2) across the plus terminal and the minus terminal at a second time after said pulse. The method further comprises calculating a voltage difference ($\Delta V$) between said first voltage and said second voltage, calculating a conductivity (G) of the battery according to $G = I_{pulse}/\Delta V$, where $I_{pulse}$ is the current of the electrical pulse. The method further comprises calculating a capacity (Q) of the battery according to:

Q=q(G), where q(G) is a capacity function that determines the capacity (Q) of the battery for a given conductivity (G).

The present invention provides a circuit for determining the capacity of a battery. The circuit comprises a switching circuit arranged between an input terminal and a plus terminal, the switching circuit is configured to control the connection between the input terminal and the plus terminal. The circuit further comprises a processing circuit configured to control the switching circuit to generate an electrical pulse, and to measure a first voltage (V1) across the plus terminal and the minus terminal at a first time during said electrical pulse. The processing circuit is further configured to measure a second voltage (V2) across the plus terminal and the minus terminal at a second time after said pulse. The processing circuit is further configured to calculate a voltage difference ($\Delta V$) between said first voltage and said second voltage, and the processing circuit is further configured to calculate conductivity (G) of the battery according to:

$$G = I_{pulse}/\ \Delta V$$

where $I_{pulse}$ is the current of the electrical pulse, the processing circuit is further configured to calculate a capacity (Q) of the battery according to:

$$Q = q(G)$$

where q(G) is a capacity function that determines the capacity (Q) of the battery for a given conductivity (G).

The invention advantageously provides an improved method, a circuit and a battery charger.

An advantage of certain embodiments is that the capacity of a battery can be determined in a fast and reliable manner.

An advantage of certain embodiments is that a charging current can be calculated for a battery connected to a battery charger.

An advantage of certain embodiments is that a charging time can be determined for the connected battery.

## LIST OF FIGURES

In the following description of embodiments of the invention, reference will be made to the accompanying drawings of which:

Fig. 1 is a flowchart for a method according to a first embodiment;

Fig. 2 is a plot illustrating the method according to the first embodiment;

Fig. 3 is a plot illustrating the method according to the first embodiment;

Fig. 4 is an illustration of a circuit according to a second embodiment of the invention;

Fig. 5 is a schematic illustration of a battery charger configured to perform the method according to the first embodiment;

Fig. 6 is a schematic block diagram of a battery charger configured to perform the method according to the first embodiment; and

Fig. 7 is an illustration of the relation between the capacity (Q) of the battery versus the conductivity (G).

## DETAILED DESCRIPTIONS OF EMBODIMENTS

The present invention will now be described more fully hereinafter with reference made to the accompanying drawings, in which preferred embodiments of the invention are shown. This invention may, however be embodied in many different forms and should not be construed as limited to the embodiments set forth herein; rather, these embodiments are provided so that this disclosure will be thorough and complete, and fully convey the scope of the invention to those skilled in the art. In the drawings, like reference signs refer to like elements.

As will be explained in detail below, the present invention teaches a way to determine the capacity of a connected battery by means of an electrical pulse applied across the terminals of the battery.

First Embodiment

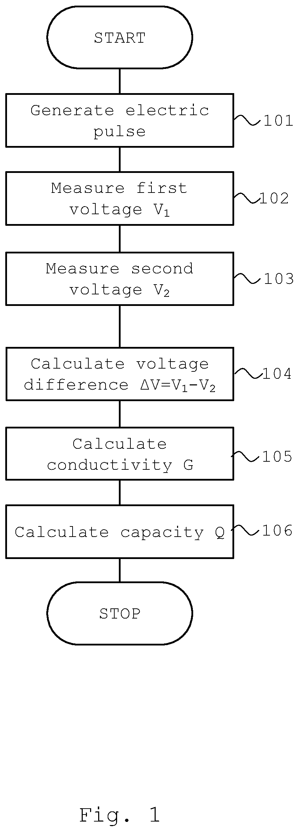

Fig. 1 is a flowchart illustrating a method according to a first embodiment of the invention.

The method comprises the following steps:

101: Generating an electrical pulse across a plus terminal and a minus terminal of the connected battery.

102: Measuring a first voltage (V1) across the plus terminal and the minus terminal at a first time during said pulse.

103: Measuring a second voltage (V2) across the plus terminal and the minus terminal at a second time after said pulse.

104: Calculating a voltage difference ($\Delta V$) between said first voltage and said second voltage.

105: Calculating conductivity (G) of the battery according to: $G = I_{pulse}/\Delta V$, where $I_{pulse}$ is the current of the electrical pulse.

106: Calculating a capacity (Q) of the battery according to: $Q = q(G)$, where $q(G)$ is a capacity function that gives the capacity (Q) of the battery for a given conductivity (G).

Second embodiment

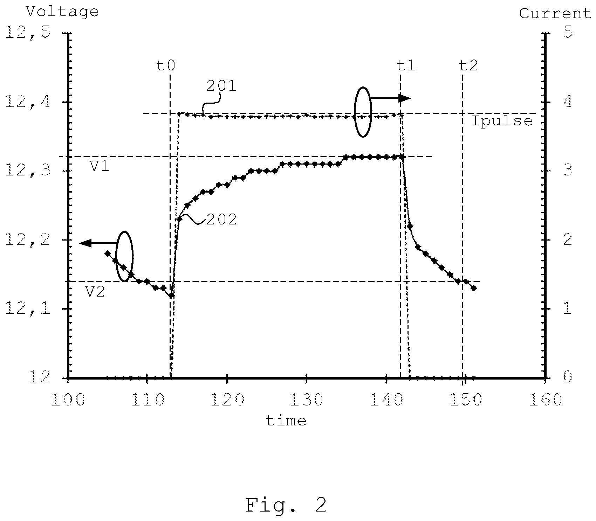

Fig. 2 shows a plot illustrating a method according to a second embodiment. A difference between the first embodiment and the second embodiment is that the electrical pulse is a constant current pulse.

At time t0 in Fig. 2 a constant current pulse 201 with an amplitude $I_{pulse}$=3.8 A is applied to a lead acid battery. During this current pulse the voltage 202 across the plus terminal and the minus terminal increases. This voltage is measured and used as the first voltage (V1). In this embodiment the measurement is performed just before time t1 when the current pulse is turned off. The voltage across the terminals of the battery decreases and at time t2 the second voltage ($V_2$) across the terminals of the battery is measured. In another embodiment the second voltage can be measured when the voltage across the terminals has decreased a predetermined amount.

All measurements needed to calculate the capacity of the battery is now performed, and the remaining steps of calculating the conductivity and the capacity are easily performed. In this embodiment a constant current pulse with amplitude of 3.8A and duration of 30s is used.

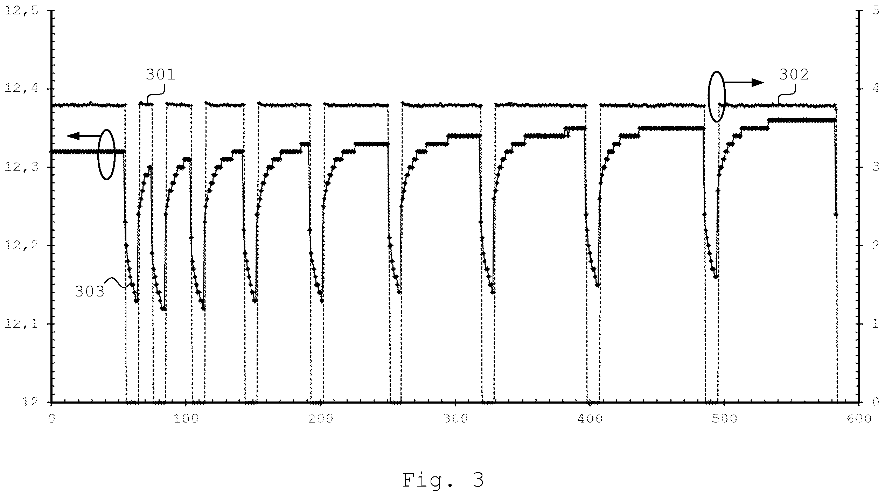

In order to further explain the inventive method a sweep with increasing pulse duration is disclosed in Fig. 3. The amplitude of the current pulse is 3.8A and the duration is increased in steps of 10 seconds, from a pulse length 301 of 10 seconds up to a pulse length 302 of 90 seconds. From Fig. 3 it is obvious that the voltage across the terminals of the battery reaches an almost constant value after approximately 20 seconds. Therefore, in order to achieve a fast estimate of the capacity the pulse duration of 20 seconds can be used but of course longer pulses may also be used. The time interval between the current pulses is in this embodiment set to 10 seconds. Based on the voltage curve 303 in Fig. 3 this seems to be a reasonable time interval in order to allow the voltage between the terminals of the battery to return to a reasonable level.

From Fig. 3 it is also evident that the voltage difference $\Delta V = V_1 - V_2$ is independent on the state of charge (SOC) of the battery. This means that the method can be used regardless of the SOC, which is of great importance

Third Embodiment

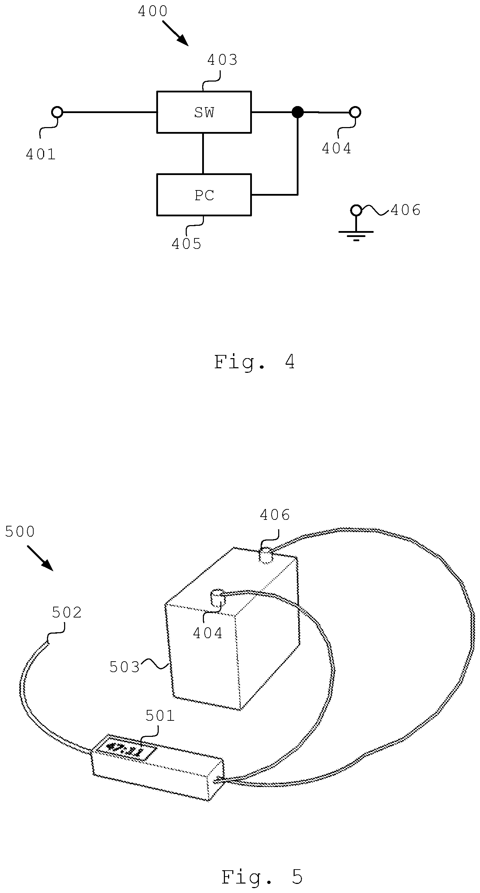

In Fig. 4 a circuit 400 is illustrated as a block diagram according to a third embodiment. The circuit 400 may perform the methods according to embodiments of the invention.

The circuit 400 comprises an input terminal 401 for receiving incoming DC power from an external power supply such as a switched mode power supply (SMPS). The input terminal 401 is connected to a switching circuit 403 that is configured to control the connection between the input terminal 401 and an output terminal 404. The circuit 400 further comprises a processing circuit 405 that is configured to control the switching circuit 403 and to measure the voltage across the output terminal 404 and a ground terminal 406. The processing circuit is further configured to measure the output current at the output terminal 404. The processing circuit may in one embodiment comprise a processor and a memory containing instructions for performing the method according to embodiments of the invention. The processing circuit can in other embodiments comprise a field programmable gate array programmed to perform methods according to embodiments disclosed herein.

Fourth Embodiment

Fig. 5 illustrates a battery charging system 500 according to a fourth embodiment of the present invention. The battery charger 501 is connected to an input power line 502 for receiving incoming power from the power grid. In Europe the incoming power can be 230 VAC and in US 110 VAC. The plus terminal 404 of the battery charger is removably connected to a plus pole of a battery 503. The minus terminal 406 of the battery charger is connected to a minus pole of the battery 503. The removable connections between the battery charger 501 and the battery 503 can be provided by means of clips, or connectors. The battery can also be connected to other equipment during charging such as a starter circuit for an internal combustion engine, for example.

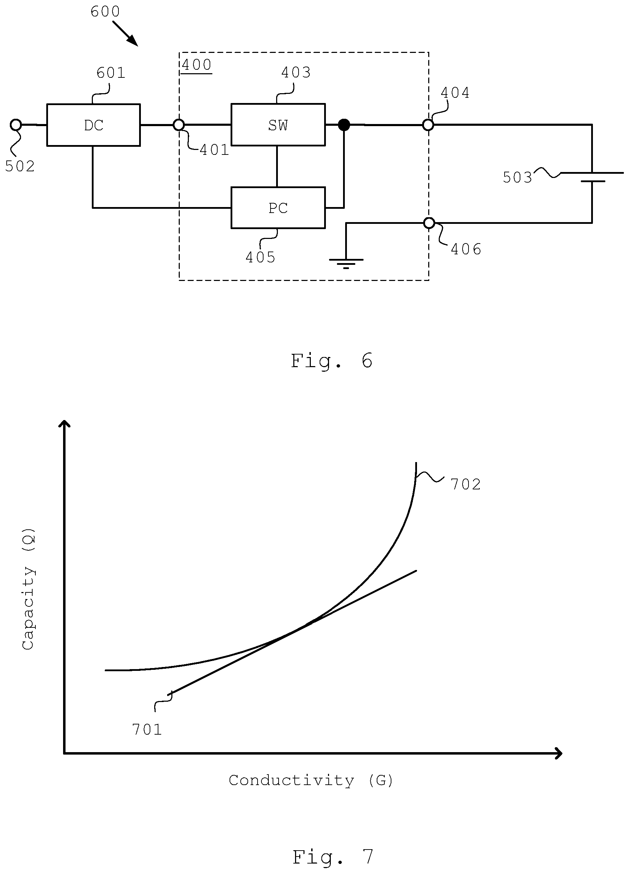

The battery charger 501 comprises a battery charger circuit disclosed in Fig. 6 as a block diagram, generally designated 600. The battery charger circuit 600 of the battery charger comprises a power converter 601 supplied with mains power from the input power line 502. The power converter can be a switched mode power supply (SMPS). Several in the art well known SMPS exist and one of the most used converters for battery chargers is the Buck converter. The Buck converter converts the input power to an output DC voltage that is lower than the voltage of the input power. The output voltage from the power converter 601 is relayed to the switching circuit 403 via the input terminal 401.

The switching circuit 403 is configured to be controlled by a processing circuit 405. The switching circuit 403 may in one embodiment comprise a MOS transistor configured to be used as a controllable switch. The processing circuit further comprises a voltage measuring circuit connected to the plus terminal 404. The voltage measuring circuit may in one embodiment be an analogue to digital converter (ADC) of the processing circuit 405.

The processing circuit 405 further comprises a current detection circuit configured to sense the current flowing from the plus terminal 404 to the connected battery 503. This current detection circuit can be a high side current detection circuit or a low side current detection circuit that may comprise a current shunt with a differential amplifier arranged to sense the voltage drop over said current shunt.

The processing circuit 405 comprises in one embodiment a processor and a memory. The memory comprises instructions to perform the method as disclosed in embodiments of the present invention when executed by the processor. In one embodiment the calculated capacity (Q) of the connected battery is used to determine the charging current supplied from the battery charger 501 to the connected battery 503. This can be especially useful if a high performance battery charger is used to charge a small battery, such as a motorcycle battery.

The calculated capacity can also be used to determine the estimated charging time (t) for a fully discharged battery:

$$t = Q / I_{charge}$$

where $I_{charge}$ is the charging current from the battery charger to the connected battery.

In order to determine the remaining charging time for a partly discharged battery, the state of charge (SOC) needs to be determined in order to compensate the estimated charging time for a fully discharged battery. Several methods for determining the SOC exists in the art.

This ability to perform a fast estimate of the charging time (t) is extremely useful for a user of the battery charger. The charging time estimate can be available within 30 seconds after the connection of the battery to the battery charger.

In one embodiment, the battery charger 501 comprises a display configured to display information about the estimated charging time.

In one embodiment, the battery charger is configured to use the estimated charging time according to embodiments of this disclosure as a first estimate of the charging time. After approximately 15 minutes the battery charger is configured to use a more precise model to estimate the charging time based on the current history. Such more precise models are well known in the art but the drawback of these models is that they require approximately 30 minutes of historic data to be precise.

Fifth Embodiment

Fig. 7 discloses relations between the measured conductivity (G) and the capacity of the connected battery (Q) according to a fifth embodiment.

In Fig. 7 the relation between the conductivity (G) and the capacity (Q) is illustrated. The exact relation depends on the type of chemistry used in the battery; therefore in Fig. 7 the relations are merely indicative. The exact relation is revealed by a simple measurement in the laboratory for the chemistry of interest. The simplest relation can be illustrated as a linear curve 701. This linear curve 701 represents a linear dependency on the conductivity (G) for the capacity (Q). A more complex relation is illustrated as a non-linear curve 702. The non-linear curve 702 represents a non-linear dependency on the conductivity (G) for the capacity (Q). The non-linear dependency can in one embodiment be an exponential expression of the conductivity.

This information about the dependency of the conductivity (G) for the capacity (Q) can be stored in the processing circuit as either an equation or as a look-up table.

The present invention has devised a way to determine the capacity of a connected battery by means of a method, a circuit and a battery charger. The list of example embodiments is not exhaustive but rather included in order to describe the inventive concept.

The above mentioned and described embodiments are only given as examples and should not be limiting to the present invention.

**Claims**

1. A method for determining a capacity of a battery connectable to a battery charger, the method comprising:

   generating an electrical pulse across a plus terminal and a minus terminal of the battery;

   measuring a first voltage ($V_1$) across the plus terminal and the minus terminal at a first time during said pulse;
   measuring a second voltage ($V_2$) across the plus terminal and the minus terminal at a second time after said pulse;
   calculating a voltage difference ($\Delta V$) between said first voltage and said second voltage;

   the method is **characterised by**: calculating a conductivity (G) of the battery according to:

   $$G = I_{pulse} / \Delta V$$

   where $I_{pulse}$ is the current of the electrical pulse; calculating a capacity (Q) of the battery according to:

   $$Q = q(G)$$

   where q(G) is a capacity function that gives the capacity (Q) of the battery for a given conductivity (G) .

2. A method according to claim 1, wherein the electrical pulse is a constant current pulse.

3. A method according to claim 2, wherein the constant current pulse has a predetermined duration in time.

4. A method according to claim 3, wherein the constant current pulse has a predetermined time duration in intervals of from 15 seconds up to 90 seconds.

5. A method according to claim 4, wherein the constant current pulse has a predetermined time duration in intervals of from 15 seconds up to 30 seconds.

6. A method according to claim 1, wherein the first time is at an end of the electrical pulse.

7. A method according to claim 1, wherein the second time is at a predetermined time length from said first time.

8. A method according to claim 1, wherein the capacity function is a linear function of the conductivity:

   $$q(G) = k \cdot G$$

   where k is a battery constant.

9. A method according to claim 8, wherein the battery constant k depend on the battery chemistry of the battery.

10. A method according to claim 1, wherein the capacity function comprises an exponential expression of the conductivity.

11. A method according to any of the preceding claims, further comprising calculating a remaining charging time based on said determined capacity of the battery, according to t=Q/I$_{charge}$, where I$_{charge}$ is the charging current from the battery charging system to the connected battery.

12. A circuit (400) for determining a capacity of a battery connectable to a battery charger, comprising:

a switching circuit (403) arranged between a power input terminal (401) and a plus terminal (404), the switching circuit (403) is configured to control the connection between the input terminal (401) and the plus terminal (404);
a processing circuit (405) configured to control the switching circuit (403) to generate an electrical pulse, and to measure a first voltage (V1) across the plus terminal (404) and a minus terminal (406) at a first time during said electrical pulse, the processing circuit (405) is further configured to measure a second voltage (V2) across the plus terminal (404) and the minus terminal (406) at a second time after said pulse, the processing circuit (405) is further configured to calculate a voltage difference (∆V) between said first voltage and said second voltage, and the processing circuit (405) is
**characterised in that** it is further configured to calculate a conductivity (G) of the battery according to:

$$G=I_{pulse}/\Delta V$$

where I$_{pulse}$ is the current of the electrical pulse, the processing circuit is further configured to calculate a capacity (Q) of the battery according to:

$$Q=q(G)$$

where q(G) is a capacity function that determines the capacity (Q) of the battery for a given conductivity (G).

13. A circuit according to claim 12, wherein the switching circuit is configured to generate a constant current pulse.

14. A circuit according to claim 13, wherein the switching circuit is configured to generate a constant current pulse with a predetermined duration in time.

15. A circuit according to claim 14, wherein the switching circuit is configured to generate a constant current pulse with a predetermined time duration at intervals of from 15 seconds up to 90 seconds.

16. A circuit according to claim 14, wherein the switching circuit is configured to generate a constant current pulse with a predetermined time duration at intervals of from 15 seconds up to 30 seconds.

17. A battery charging system, comprising:

a power converter connected to an input terminal for receiving power, the power converter is configured to convert an incoming voltage to an output voltage;
a circuit (400) for determining a capacity of a connectable battery, comprising:

a power input terminal (401) for receiving electrical power;
a plus terminal (404) configured to be connected to a plus pole of a battery;
a minus terminal (406) configured to be connected to a minus pole of the battery;
the circuit (400) according to any one of claims 11-16.

18. A battery charging system according to claim 17, wherein the processing circuit (405) is configured to calculate a remaining charging time based on said determined capacity of the battery, according to:
t=Q/I$_{charge}$, where I$_{charge}$ is the charging current from the battery charging system to the connected battery.

19. A battery charging system according to claim 17, wherein the processing circuit (405) is configured to calculate a charging current based on the calculated capacity Q.

**Patentansprüche**

1. Verfahren zum Ermitteln einer Kapazität einer Batterie, die mit einem Batterieladegerät verbunden werden kann, wobei das Verfahren Folgendes umfasst:

Erzeugen eines elektrischen Pulses über einen positiven Anschluss und einen negativen Anschluss der Batterie;
Messen einer ersten Spannung (V1) über den positiven Anschluss und den negativen Anschluss zu einer ersten Zeit während des Pulses;
Messen einer zweiten Spannung (V2) über den positiven Anschluss und den negativen Anschluss zu einer zweiten Zeit nach dem Puls;

Berechnen einer Spannungsdifferenz (ΔV) zwischen der ersten Spannung und der zweiten Spannung;

wobei das Verfahren **gekennzeichnet ist durch**:

Berechnen einer Leitfähigkeit (G) der Batterie gemäß:

$$G=I_{pulse}/\Delta V$$

wo $I_{pulse}$ die Stromstärke des elektrischen Pulses ist; Berechnen einer Kapazität (Q) der Batterie gemäß:

$$Q=q(G)$$

wo q(G) eine Kapazitätsfunktion ist, die die Kapazität (Q) der Batterie für eine vorgegebene Leitfähigkeit (G) ergibt.

2. Verfahren nach Anspruch 1, wobei der elektrische Puls ein Puls mit konstanter Stromstärke ist.

3. Verfahren nach Anspruch 2, wobei der Puls mit konstanter Stromstärke eine vorbestimmte Zeitdauer aufweist.

4. Verfahren nach Anspruch 3, wobei der Puls mit konstanter Stromstärke eine vorbestimmte Zeitdauer in Intervallen von 15 Sekunden bis zu 90 Sekunden aufweist.

5. Verfahren nach Anspruch 4, wobei der Puls mit konstanter Stromstärke eine vorbestimmte Zeitdauer in Intervallen von 15 Sekunden bis zu 30 Sekunden aufweist.

6. Verfahren nach Anspruch 1, wobei die erste Zeit am Ende des elektrischen Pulses ist.

7. Verfahren nach Anspruch 1, wobei die zweite Zeit eine vorbestimmte Zeitlänge ab der ersten Zeit an ist.

8. Verfahren nach Anspruch 1, wobei die Kapazitätsfunktion eine lineare Funktion der Leitfähigkeit ist:

$$q(G)=k\cdot G$$

wo k eine Batteriekonstante ist.

9. Verfahren nach Anspruch 8, wobei die Batteriekonstante k von der Batteriechemie der Batterie abhängt.

10. Verfahren nach Anspruch 1, wobei die Kapazitätsfunktion einen exponentiellen Ausdruck der Leitfähigkeit umfasst.

11. Verfahren nach einem der vorstehenden Ansprüche, weiter umfassend Berechnen einer verbleibenden Ladezeit, basierend auf der ermittelten Kapazität der Batterie gemäß $t=Q/I_{charge}$, wo $I_{charge}$ die Ladestromstärke des Batterieladesystems zu der verbundenen Batterie ist.

12. Schaltkreis (400) zum Ermitteln einer Kapazität einer Batterie, die mit einem Batterieladegerät verbunden werden kann, der Folgendes umfasst:

einen Wechselschaltkreis (403), der zwischen einem Leistungseingangsanschluss (401) und einem positiven Anschluss (404) eingerichtet ist, wobei der Wechselschaltkreis (403) konfiguriert ist, die Verbindung zwischen dem Eingangsanschluss (401) und dem positiven Anschluss (404) zu steuern;

einen Verarbeitungsschaltkreis (405), der konfiguriert ist, den Wechselschaltkreis (403) zu steuern, um einen elektrischen Puls zu erzeugen, und eine erste Spannung (V1) über den positiven Anschluss (404) und einen negativen Anschluss (406) zu einer ersten Zeit während des elektrischen Pulses zu messen, wobei der Verarbeitungsschaltkreis (405) weiter konfiguriert ist, eine zweite Spannung (V2) über den positiven Anschluss (404) und den negativen Anschluss (406) zu einer zweiten Zeit nach dem Puls zu messen, wobei der Verarbeitungsschaltkreis (405) weiter konfiguriert ist, eine Spannungsdifferenz (AV) zwischen der ersten Spannung und der zweiten Spannung zu berechnen, und wobei der Verarbeitungsschaltkreis (405)

**dadurch gekennzeichnet ist, dass** er weiter konfiguriert ist, eine Leitfähigkeit (G) der Batterie gemäß Folgendem zu berechnen:

$$G=I_{pulse}/\Delta V$$

wo $I_{pulse}$ die Stromstärke des elektrischen Pulses ist, wobei der Verarbeitungsschaltkreis weiter konfiguriert ist, eine Kapazität (Q) der Batterie gemäß Folgendem zu berechnen:

$$Q=q\cdot(G)$$

wo q(G) eine Kapazitätsfunktion ist, die die Kapazität (Q) der Batterie für eine vorgegebene Leitfähigkeit (G) ermittelt.

13. Schaltkreis nach Anspruch 12, wobei der Wechselschaltkreis konfiguriert ist, einen Puls mit konstanter Stromstärke zu erzeugen.

14. Schaltkreis nach Anspruch 13, wobei der Wechselschaltkreis konfiguriert ist, einen Puls mit konstanter Stromstärke mit einer vorbestimmten Zeitdauer zu erzeugen.

15. Schaltkreis nach Anspruch 14, wobei der Wechselschaltkreis konfiguriert ist, einen Puls mit konstanter Stromstärke mit einer vorbestimmten Zeitdauer bei Intervallen von 15 Sekunden bis zu 90 Sekunden zu erzeugen.

16. Schaltkreis nach Anspruch 14, wobei der Wechselschaltkreis konfiguriert ist, einen Puls mit konstanter Stromstärke mit einer vorbestimmten Zeitdauer bei Intervallen von 15 Sekunden bis zu 30 Sekunden zu erzeugen.

17. Batterieladesystem, das Folgendes umfasst:

einen Leistungswandler, der mit einem Eingangsanschluss verbunden ist, um Leistung zu empfangen, wobei der Leistungswandler konfiguriert ist, eine eingehende Spannung zu einer Ausgangsspannung umzuwandeln;
einen Schaltkreis (400) zum Ermitteln einer Kapazität einer verbindbaren Batterie, der Folgendes umfasst:

einen Leistungseingangsanschluss (401) zum Empfangen elektrischer Leistung;
einen positiven Anschluss (404), der konfiguriert ist, mit einem Plus-Pol einer Batterie verbunden zu werden;
einen negativen Anschluss (406), der konfiguriert ist, mit einem Minus-Pol der Batterie verbunden zu werden;
den Schaltkreis (400) nach einem der Ansprüche 11-16.

18. Batterieladesystem nach Anspruch 17, wobei der Verarbeitungsschaltkreis (405) konfiguriert ist, eine verbleibende Ladezeit basierend auf der ermittelten Kapazität der Batterie gemäß Folgendem zu berechnen:
$t=Q/I_{charge}$, wo $I_{charge}$ die Ladestromstärke des Batterieladesystems zu der verbundenen Batterie ist.

19. Batterieladesystem nach Anspruch 17, wobei der Verarbeitungsschaltkreis (405) konfiguriert ist, eine Ladestromstärke basierend auf der berechneten Kapazität Q zu berechnen.

**Revendications**

1. Procédé de détermination d'une capacité d'une batterie pouvant être connectée à un chargeur de batterie, le procédé comprenant :

la génération d'une impulsion électrique entre une borne positive et une borne négative de la batterie ;
la mesure d'une première tension ($V_1$) entre la borne positive et la borne négative à un premier instant au cours de ladite impulsion ;
la mesure d'une seconde tension ($V_2$) entre la borne positive et la borne négative à un second instant après ladite impulsion ;
le calcul d'une différence de tension ($\Delta V$) entre ladite première tension et ladite seconde tension ;
le procédé est **caractérisé par** :
le calcul d'une conductivité (G) de la batterie en fonction de :

$$G=I_{impulsion}/\Delta V$$

où $I_{impulsion}$ est le courant de l'impulsion électrique; le calcul d'une capacité (Q) de la batterie en fonction de :

$$Q=q(G)$$

où q(G) est une fonction de capacité qui donne la capacité (Q) de la batterie pour une conductivité (G) donnée.

2. Procédé selon la revendication 1, dans lequel l'impulsion électrique est une impulsion à courant constant.

3. Procédé selon la revendication 2, dans lequel l'impulsion à courant constant présente une durée prédéterminée dans le temps.

4. Procédé selon la revendication 3, dans lequel l'impulsion à courant constant présente une durée prédéterminée dans des intervalles de 15 secondes jusqu'à 90 secondes.

5. Procédé selon la revendication 4, dans lequel l'impulsion à courant constant présente une durée prédéterminée dans des intervalles de 15 secondes jusqu'à 30 secondes.

6. Procédé selon la revendication 1, dans lequel le premier instant est à une fin de l'impulsion électrique.

7. Procédé selon la revendication 1, dans lequel le second instant est à une longueur de temps prédéterminé à partir dudit premier instant.

8. Procédé selon la revendication 1, dans lequel la fonction de capacité est une fonction linéaire de la conductivité :

$$q(G)=k \cdot G$$

où k est une constante de batterie.

9. Procédé selon la revendication 8, dans lequel la constante k de batterie dépend de la chimie de batterie de la batterie.

10. Procédé selon la revendication 1, dans lequel la fonction de capacité comprend une expression exponentielle de la conductivité.

11. Procédé selon l'une quelconque des revendications précédentes, comprenant en outre le calcul d'un temps de charge restant sur la base de ladite capacité déterminée de la batterie, en fonction de $t=Q/I_{charge}$, où $I_{charge}$ est le courant de charge allant du système de charge de batterie à la batterie connectée.

12. Circuit (400) pour déterminer une capacité d'une batterie pouvant être connectée à un chargeur de batterie, comprenant :

un circuit de commutation (403) agencé entre une borne d'entrée de puissance (401) et une borne positive (404), le circuit de commutation (403) est configuré pour commander la connexion entre la borne d'entrée (401) et la borne positive (404) ;
un circuit de traitement (405) configuré pour commander le circuit de commutation (403) pour générer une impulsion électrique, et pour mesurer une première tension (V1) entre la borne positive (404) et une borne négative (406) à un premier instant au cours de ladite impulsion électrique, le circuit de traitement (405) est configuré en outre pour mesurer une seconde tension (V2) entre la borne positive (404) et la borne négative (406) à un second instant après ladite impulsion, le circuit de traitement (405) est configuré en outre pour calculer une différence de tension ($\Delta V$) entre ladite première tension et ladite seconde tension, et le circuit de traitement (405) est **caractérisé en ce qu'**il est configuré en outre pour calculer une conductivité (G) de la batterie en fonction de :

$$G=I_{impulsion}/\Delta V$$

où $I_{impulsion}$ est le courant de l'impulsion électrique, le circuit de traitement est configuré en outre pour calculer une capacité (Q) de la batterie en fonction de :

$$Q=q \cdot (G)$$

où q(G) est une fonction de capacité qui détermine la capacité (Q) de la batterie pour une conductivité (G) donnée.

13. Circuit selon la revendication 12, dans lequel le circuit de commutation est configuré pour générer une impulsion à courant constant.

14. Circuit selon la revendication 13, dans lequel le circuit de commutation est configuré pour générer une impulsion à courant constant avec une durée prédéterminée dans le temps.

15. Circuit selon la revendication 14, dans lequel le circuit de commutation est configuré pour générer une impulsion à courant constant avec une durée prédéterminée à des intervalles de 15 secondes jusqu'à 90 secondes.

16. Circuit selon la revendication 14, dans lequel le circuit de commutation est configuré pour générer une impulsion à courant constant avec une durée prédéterminée à des intervalles de 15 secondes jusqu'à 30 secondes.

17. Système de charge de batterie, comprenant :

un convertisseur de puissance connecté à une borne d'entrée pour recevoir une puissance, le convertisseur de puissance est configuré pour convertir une tension entrante en une tension de sortie ;
un circuit (400) pour déterminer une capacité d'une batterie pouvant être connectée, comprenant :

un borne d'entrée de puissance (401) pour recevoir une puissance électrique ;
une borne positive (404) configurée pour être connectée à un pôle positif d'une batterie ;
une borne négative (406) configurée pour être connectée à un pôle négatif de la batterie ;
le circuit (400) selon l'une quelconque des revendications 11-16.

**18.** Système de charge de batterie selon la revendication 17, dans lequel le circuit de traitement (405) est configuré pour calculer un temps de charge restant sur la base de ladite capacité déterminée de la batterie, en fonction de :

t=$Q/I_{Charge}$, où $I_{charge}$ est le courant de charge allant du système de charge de batterie à la batterie connectée.

**19.** Système de charge de batterie selon la revendication 17, dans lequel le circuit de traitement (405) est configuré pour calculer un courant de charge sur la base de la capacité Q calculée.

START

Generate electric pulse — 101

Measure first voltage $V_1$ — 102

Measure second voltage $V_2$ — 103

Calculate voltage difference $\Delta V = V_1 - V_2$ — 104

Calculate conductivity G — 105

Calculate capacity Q — 106

STOP

Fig. 1

Fig. 2

Fig. 3

Fig. 4

Fig. 5

Fig. 6

Fig. 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5926007 A
- US 6928372 B
- US 2002075003 A1

**Non-patent literature cited in the description**

- **W. PEUKERT.** *Elektrotechnische Zeitsschrift,* 1997, vol. 20, 20-21